# EUROPEAN PATENT APPLICATION

(11) **EP 4 428 929 A1**
(43) Date of publication of application: **11.09.2024**
(21) Application number: 24305308.9
(22) Date of filing: 27.02.2024
(51) Int. Cl.: H01L 29/778, H01L 21/337, H01L 29/10, H01L 29/40, H01L 29/20

(54) **HEMT DEVICE HAVING A REDUCED GATE LEAKAGE AND MANUFACTURING PROCESS THEREOF**

(30) Priority: 10.03.2023 IT 202300004536
(71) Applicant: STMicroelectronics International N.V., 1228 Plan-les-Ouates, Geneva (CH)
(72) Inventor: IUCOLANO, Ferdinando, 95030 GRAVINA DI CATANIA (CT) (IT); CONSTANT, Aurore, 37100 TOURS (FR); TRINGALI, Cristina, 96011 AUGUSTA (SR) (IT); CASTAGNA, Maria Eloisa, 95123 CATANIA (IT)
(74) Representative: Studio Torta S.p.A.

(57) **Abstract**

An HEMT device (50) is formed on a semiconductor body (52) having a semiconductive heterostructure (54, 56). A control region (57) of a semiconductor material, is arranged on the semiconductor body (52) and has a top surface and lateral sides. A control terminal (68), of conductive material, extends on and in contact with the top surface of the control region (57). A passivation layer (58) of non-conductive material, extends on the semiconductor body (52), partially on the top surface of the control region (57) and on the lateral sides of the control region (57), laterally and at a distance from the control terminal (68).

## Description

### Technical Field

The present invention relates to a High Electron Mobility Transistor (HEMT) device having a reduced gate leakage and to the manufacturing process thereof.

### Background

As known, HEMT devices, often referred to as heterostructure field effect transistors (HFET), are finding wide diffusion in high-power and fast switching applications, thanks to the possibility of operating at high voltages, owing to their high breakdown voltage and to the high carrier density and mobility.

In an HEMT device, a semiconductive heterostructure (based generally on AlGaN/GaN layers) allows a so-called 2-dimensional electron gas (2DEG) to be spontaneously generated in the device, thereby forming a channel path for electrical charges. The spontaneous channel may be modulated by applying suitable voltages at a gate region, over the channel path.

AlGaN/GaN HEMTs are normally depletion-mode. However, for practical applications, enhancement mode (normally-off) devices are preferred to obtain safe operation and to drive circuits simplification.

Several approaches to achieve normally-off HEMTs based on AlGaN/GaN layers have been proposed, including forming recessed gate transistors, carrying out manufacturing steps such as incorporating fluorine plasma under the gate, or forming a gate region of pGaN. The last solution is for example used in products available on the market and considered hereinbelow.

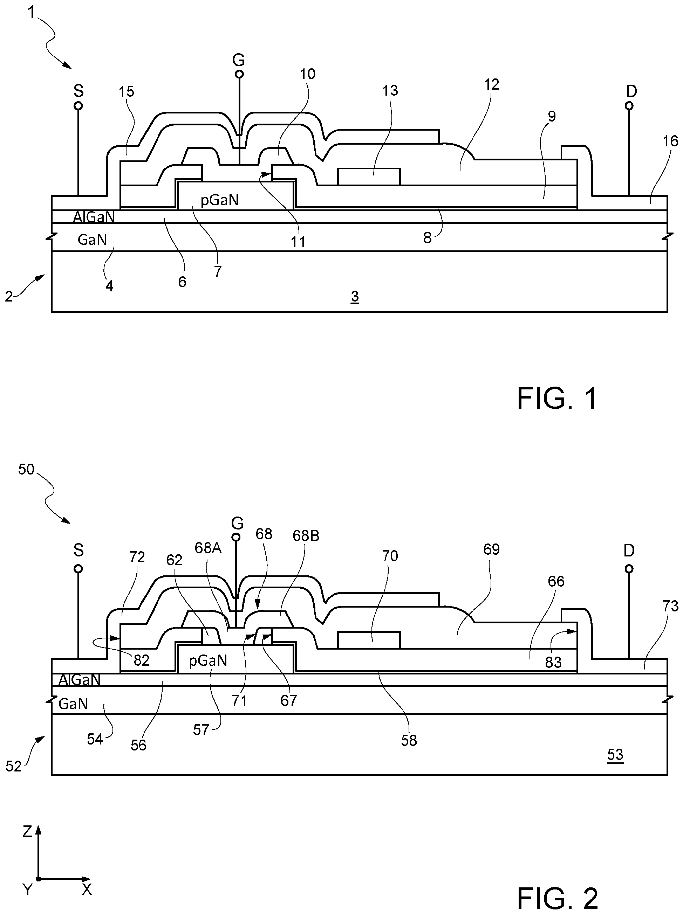

For example, Figure 1 shows an HEMT device 1, formed on a semiconductor body 2, here comprising a substrate layer 3, a first layer 4 and a second layer 6 (hereinafter also referred to as channel layer 4 and barrier layer 6).

Substrate layer 3 may comprise a silicon substrate and gallium nitride (GaN) buffer layer, not shown separately in Figure 1.

Channel layer 4 is of a first semiconductor material, such as, for example, a first semiconductive alloy of elements of the groups III-V of the periodic table; for example, the channel layer 4 may be of gallium nitride (GaN).

Barrier layer 6 overlies, and is in direct contact with, the channel layer 4, and is of a second semiconductor material, such as, for example, a second semiconductive alloy, different from the first semiconductive alloy, of elements of the groups III-V of the periodic table. For example, barrier layer 6 may be of aluminium gallium nitride (AlGaN) .

Channel layer 4 and barrier layer 6 are for example of N-type.

A gate region 7, of conductive material, extends on barrier layer 6. Gate region 7 is formed, for example, by a third semiconductor material, such as for example a third semiconductive alloy of elements of the groups III-V of the periodic table; in more detail, gate region 7 is formed here by gallium nitride of P conductivity type (pGaN).

A passivation layer 8 covers the top surface of barrier layer 6, laterally to the gate region 7, as well as the lateral surfaces ("sidewalls") and, partially, the top surface of the gate region 7. The passivation layer 8 is formed by a layer of a non-conductive material, for example an oxide, such as Al₂O₃.

A first insulating layer 9, for example of silicon oxide, extends on the passivation layer 8.

An opening 11 extends throughout the first insulating layer 9 and the passivation layer 8, on top of the gate region 7, and a gate metal region 10, for example of TiN/AlCu/TiN, extends in the opening 11, in direct electrical contact with the gate region 7, and partially on the first insulating layer 9.

A second insulating layer 12, for example of silicon oxide, extends on the first insulating layer 9 and on the gate metal region 10.

In Figure 1, a field plate 13, of conductive material, extends on the first insulating layer 9, laterally to the gate metal region 10, and below the second insulating layer 12. Field plate 13 is optional and is possibly formed from a same metal layer as the gate metal region 10.

A source metal region 15, for example of Ti/AlCu/TiN, extends on and in direct electrical contact with the barrier layer 6; source metal region 15 also extends laterally to and on the second insulating layer 12. In HEMT device 1, source metal region 15 has a portion extending over gate metal region 10 and over field plate region 13 and has a shielding function.

A drain metal region 16, for example of Ti/AlCu/TiN, extends on and in direct electrical contact with barrier layer 6; in addition, drain metal region 16 extends laterally to and, partially, on the second insulating layer 12 (on an opposite side of the gate region 7 with respect to source metal region 15.

In this type of HEMT transistors, etching of the layers over semiconductor body 2 is critic and may affect the electrical performances of the device, such as the threshold voltage.

In fact, the threshold voltage of an HEMT device is influenced by any gate leakage occurring in particular on the sidewalls of the gate region 7 and may be subject to shifts during stress conditions: typically, a negative shift of the threshold voltage derives from a high-leakage gate region 7. On the other side, a low-leakage gate region 7 gives rise to a positive shift of the threshold voltage. In commercial devices, a trade-off between the positive and the negative shifts is desired.

The gate leakage presents a bulk contribution and a parasitic contribution during device operation (i.e., when the control voltage applied on the gate terminal is greater than zero).

In particular, the parasitic contribution originates on the top surface of the gate region 7 (i.e., on the portions where a Schottky contact between the gate metal region 10 and the gate region 7 is not present) and on the sidewalls of the gate region 7.

The parasitic gate leakage through the top surface of the pGaN material is due to the presence of electronic surface states induced by a polarization net charge, intrinsic when stacking GaN-AlGaN-pGaN layers for HEMT transistors of the considered type.

The parasitic gate leakage through the sidewalls of the gate region 7 is instead process-dependent and, specifically, is due to the etching conditions, in terms of chemistry and power employed, of the pGaN layer when forming the gate region 7. In detail, damages caused by etching may bring to the formation of vacancies, such as nitrogen vacancies, resulting in the sidewalls of the gate region 7 trapping a high concentration of electrons. Thereby, a current leakage path is formed, from lower edges of the gate metal region 10, along the sidewalls of the gate region 7, toward barrier layer 6 and channel layer 4 (that is, in an operative condition of HEMT device 1, toward the channel region of the HEMT device 1). In other words, the pGaN etching may cause the presence of a depleted superficial side portion of the gate region 7; thus, the formation of an inversion channel on the sidewalls of gate region 7 arises when the 2DEG is formed at the interface between channel layer 4 and barrier layer 6 (when HEMT device 1 is on).

The bulk gate leakage contribution is mainly influenced by: damages of the gate region 7, e.g., due to partial removal or roughness of the pGaN material, during the formation of the gate metal region 10 through etching; and the concentration of doping ions, such as magnesium, defining the p-type doping of the GaN material forming the gate region 7.

Surface passivation of the barrier layer 6 and of the gate region 7, through atomic layer deposition ("ALD") of ammonium hydroxide resistant materials (such as Al₂O₃ or AlN), as done by passivation layer 8, is a known solution in an attempt to compensate for the presence of electronic surface states and for the defects caused by the pGaN etching.

Other known solutions are disclosed, for example, in US 2022/310824 A1 and in US 11201234 B1. In US 2022/310824 A1, an HEMT device comprising spacers formed on a semiconductor gate layer and on sidewalls of a metal gate layer is presented; a passivation layer is formed to cover the barrier layer, the semiconductor gate layer, and the metal gate layer (i.e., the spacers); however, the passivation layer extends on the spacers but is not in contact with the top surface of the semiconductor gate layer. US 11201234 B1 discloses structures of source and drain electrodes for an HEMT device comprising, among the others, a cap layer and an etch stop layer (forming a stack structure), a passivation layer and a first interlayer dielectric; in detail, the passivation layer covers the barrier layer, the lateral sides of the stack structure and partially the top surface of the etch stop layer; the first interlayer dielectric overlies; in this type of device, therefore, the passivation layer is not arranged at a distance from the etch stop layer (nor from the gate electrode), but is rather in contact with them.

The applicant verified that the deposition of such layers is not always enough effective to significantly reduce the gate leakage. Moreover, in some cases, arranging such surface passivation may introduce detrimental effects, influencing other electrical characteristics of the transistor: the dielectric parameters (e.g., thickness and material) of the passivation layer 8 affect in opposite way the gate leakage and the on-resistance Ron of the device; therefore, optimal values leading to a reduction of the gate leakage may cause a worsening in the on-resistance Ron.

Thus, an aim of the invention is to overcome the drawbacks and limitations of the prior art.

### Summary

According to the present invention, there are provided an HEMT device and the manufacturing process thereof, as defined in the attached claims.

### Brief Description of the Drawings

For the understanding of the present invention, embodiments thereof are now described, purely as non-limitative examples, with reference to the enclosed drawings, wherein:
- Figure 1 is a cross-section of a known HEMT device;
- Figure 2 is a cross-section of an HEMT device according to an embodiment;
- Figures 3A-3F are cross-sections of a semiconductor wafer in subsequent manufacturing steps of the HEMT device of Figure 2;
- Figure 4 is a cross-sections of an HEMT device according to another embodiment;
- Figures 5A-5C are cross-sections of a semiconductor wafer in subsequent manufacturing steps of the HEMT device of Figure 4; and
- Figures 6 and 7 are cross-sections of an HEMT device according to different embodiments.

### Description of Embodiments

The following description refers to the arrangement shown in the drawings; consequently, expressions such as "above", "below", "upper", "lower", "top", "bottom", "right", "left" and the like are relative to the attached figures and should not be interpreted in a limiting way.

Figure 2 shows an HEMT device 50, comprising a semiconductor body 52, here formed by a substrate layer 53, a channel layer 54 and barrier layer 56.

Substrate layer 53 may comprise a silicon substrate and gallium nitride (GaN) buffer layer, not shown separately in Figure 2.

Channel layer 54 is of a first semiconductor material, such as a first semiconductive alloy of elements of the groups III and V of the periodic table; for example, channel layer 54 may be of gallium nitride (GaN).

Barrier layer 56 overlies, and is in direct contact with, channel layer 54, and is of a second semiconductor material, such as a second semiconductive alloy, different from the first semiconductive alloy, of elements of the groups III-V of the periodic table. For example, barrier layer 56 may be of aluminium gallium nitride (AlGaN).

Channel layer 54 and barrier layer 56 are for example of N-type.

A gate region 57, of conductive material, extends on and in contact with barrier layer 56. Gate region 57 is a control region and, specifically, a channel modulating region.

In a manner not shown, gate region 57 is strip-shaped and extends along a first horizontal axis Y of a cartesian reference system XYZ. Gate region 57 is formed of a conductive material, typically a doped third semiconductor material, such as a third semiconductive alloy of elements of the groups III-V of the periodic table; specifically, gate region 57 is formed here by gallium nitride of P conductivity type (pGaN).

As known to the person skilled in the art, gate region 57 operates to modulate the thickness of the channel formed at the interface between the channel layer 54 and the barrier layer 56, based on the voltage applied thereto.

A passivation layer 58 covers the top surface of barrier layer 56, as well as the lateral surfaces (also indicated as sidewalls of gate region 57) and, partially, the top surface of the gate region 57. Analogously to the gate region 57, the passivation layer 58 also extends along the first horizontal axis Y for the entire length of gate region 57.

The passivation layer 58 is of a non-conductive material, for example an oxide, such as Al₂O₃, AlN, SiN, HfO₂, SiO₂, AlSiO, that has a thickness comprised between 2 and 10 nm, for example of 5 nm.

A first insulating layer 66, for example of silicon oxide, extends on passivation layer 58.

A gate opening 67 extends throughout the first insulating layer 66 and the passivation layer 58, on top of gate region 57.

Spacer regions 62 extend in the gate opening 67, on lateral sides thereof, on and in direct contact with the top surface of the gate region 57.

Spacer regions 62 are here strip-shaped and extend along first horizontal axis Y. In practice, spacer regions 62 laterally delimit a spacer opening 71, narrower than gate opening 67.

Spacer regions 62 are here of a dielectric material, such as silicon nitride ("SiN"), for example in its stable configuration Si₃N₄. The dielectric material of the spacer regions 62 may be an oxide but is typically different from the material of the first insulating layer 66.

A control terminal, hereinafter indicated as gate metal region 68, for example a multilayer of TiN/AlCu/TiN, extends in spacer opening 71, in direct electrical contact with a central portion of gate region 57, on spacer regions 62 and partially on the first insulating region 66.

In practice, gate metal region 68 comprises a narrow portion 68A, extending between the spacer regions 62, and an upper portion 68B, extending on the spacer regions 62.

In other words, in the embodiment of Figure 2, spacer regions 62 extend under the gate metal region 68 and are adjacent to two opposite sides of the narrow portion 68A.

Other materials, such as Ti, Ta, TiW, TaW, may be used for the alloy of the gate metal region 68, instead of TiN.

The narrow portion 68A of gate metal region 68 and gate region 57 form a Schottky contact.

A second insulating layer 69, for example of silicon oxide, extends on first insulating layer 66 and on gate metal 68.

First and second insulating layers 66 and 69 form an insulating structure 66, 69. Insulating structure 66, 69 has a first and a second current conduction opening, hereinafter indicated, respectively, as source opening 82 and drain opening 83, extending on different sides of gate region 57. Source opening 82 and drain opening 83 extend through the entire thickness of insulating structure 66, 69 and expose barrier layer 56.

In Figure 2, a field plate 70 extends on the first insulating layer 66, on a side, but at a distance from gate metal region 68, below the second insulating layer 69. Field plate 70 is optional and is possibly formed from a same metal layer as gate metal region 68.

A first current conducting terminal, hereinafter indicated as source metal region 72, for example of Ti/AlCu/TiN, extends in source opening 82 and is here in direct electrical contact with barrier layer 56. In HEMT device 50, source metal region 72 has a portion extending also on the second insulating layers 69, over the gate metal 68 and over the field plate 70 and has a shielding function.

Source metal region 72 may be electrically connected with field plate 70.

A second current conducting terminal, hereinafter indicated as drain metal region 73, for example of Ti/AlCu/TiN, extends in drain opening 83 and is here in direct electrical contact with barrier layer 56. Drain metal region 73 is on an opposite side of gate region 57 with respect to source metal region 72.

HEMT device 50 of Figure 2 has improved performances in terms of reducing the lateral gate leakage originating from the pGaN sidewalls of gate region 57.

In more detail, with the structure of Figure 2, the spacer regions 62 are interposed between the gate metal region 68 and the passivation layer 58, thereby separating them, and stopping any current leakage path from the lower edges of the gate metal region 68, along the top surface and the sidewalls of the gate region 57, toward the channel region of the HEMT device 50, which forms during operation.

The gate current, during operation of the device, is therefore forced to flow only in a localized (here central) portion of the upper surface of gate region 57, i.e., only at the Schottky contact between the gate metal region 68 and the gate region 57.

HEMT device 50 thus allows to obtain a good trade-off between gate current, threshold voltage and on-resistance.

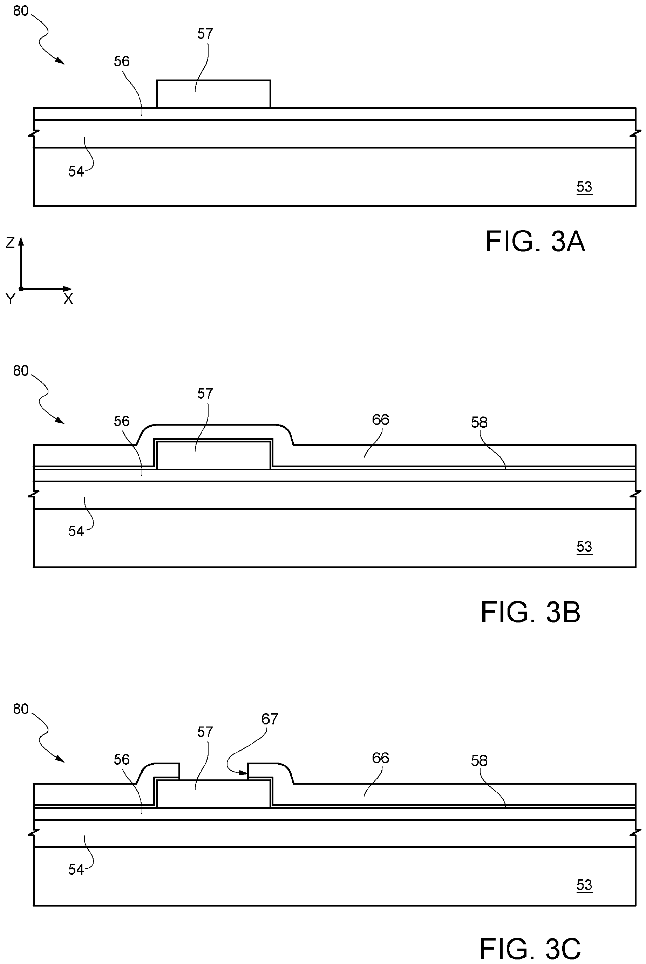

HEMT device 50 may be manufactured as shown in Figures 3A-3F, showing a wafer before dicing and using the same reference numbers as the homonymous regions in Figure 2.

Figure 3A shows a wafer 80 comprising a stack of layers including substrate layer 53, channel layer 54 and barrier layer 56. Gate region 57 has been already formed on barrier layer 56, for example by epitaxial growth of a p-doped GaN material employing MOCVD (Metal Organic Chemical Vapour Deposition) and by lithographic definition thereof, employing standard etching procedures.

In Figure 3B, passivation layer 58 is formed on gate region 57 and on barrier layer 56, where exposed, and then first insulating layer 66 is formed.

For example, passivation layer 58 is thermally or plasma deposited with an ALD (Atomic Layer Deposition) technique in a H₂O based environment at 300°C for a thickness of, e.g., 5 nm.

First insulating layer 66 may be, e.g., deposited by PECVD (Plasma Enhanced Chemical Vapour Deposition) in a SiH₄-based environment for a thickness of, e.g., 260 nm.

In Figure 3C, first insulating layer 66 and passivation layer 58 are etched using a mask (not shown) to form gate opening 67, thereby exposing the top surface of gate region 57. Etching to form gate opening 67 may be, e.g., a time etching in CF₄ or using end point detection for removing the first insulating layer 66, and a BCl₃ etching for removing passivation layer 58.

Gate opening 67 may have a width, along a second horizontal axis X of cartesian reference system XYZ, depending on the width of gate region 57, for example comprised between 0.9 µm and 5.5 µm.

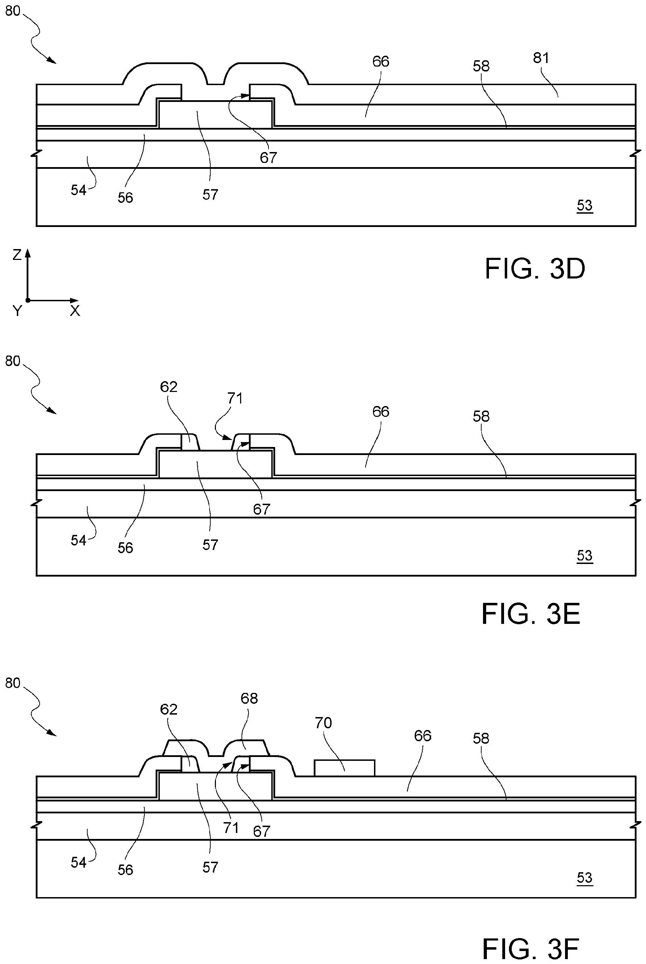

In Figure 3D, a sacrificial layer 81, of dielectric material, is formed on first insulating layer 66 and in gate opening 67, on the portion of the gate region 57 left exposed by the latter.

For example, sacrificial layer 81 is deposited by PECVD for a thickness of, e.g., 300 nm.

In Figure 3E, sacrificial layer 81 is anisotropically (dry) etched (e.g., in a CF₄ environment), without mask ("blanket"), removing it until it reaches a central portion of the top surface of the gate region 57, thereby defining spacer opening 71 - within the gate opening 67 - and forming spacer regions 62. Sacrificial layer 81 is also removed from the top of the first insulating layer 66 (outside gate opening 67).

Therefore, the spacer regions 62 may have a width, at the bottom, near gate region 57, of about 300 nm and spacer opening 71 may have a width, at the bottom, near gate region 57, comprised between 0.3 µm and 5 µm.

In this embodiment, spacer regions 62 have the same thickness of the portion of the first insulating layer 66 over the gate region 57, although this is not important.

In Figure 3F, a gate metal layer is deposited and defined to form gate metal region 68 (extending in spacer opening 71 and partially on the first insulating region 66) and field plate 70 (extending laterally thereto).

Then, in a manner not shown, second insulating layer 69 is deposited and then defined together with first insulating layer 66 and passivation layer 58 (using a mask not shown) to form source opening 82 and drain opening 83. Thereafter a source/drain metal layer is deposited and defined to form source metal region 72 and drain metal region 73.

Then final manufacturing steps follow, including depositing an outer passivation layer (not shown), forming opening contacts (not shown) and dicing the wafer 80, thereby obtaining HEMT device 50 of Figure 2.

In practice, in the above-described process, spacer regions 62, stopping lateral leakage from the gate region 57, are formed after forming gate opening 67, thereby distancing gate metal region 68 from passivation layer 58.

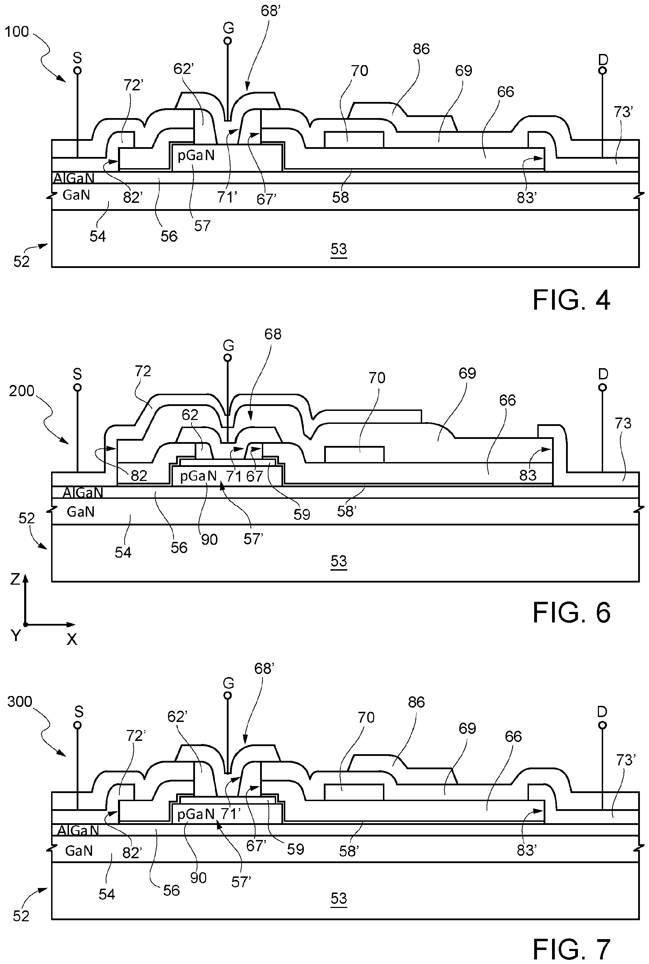

Figure 4 shows an HEMT device 100 wherein the source and the drain metal regions are formed before the gate metal region.

In detail, in Figure 4, where regions common to HEMT device 50 of Figure 2 have been indicated using the same reference numbers, source opening, here indicated by 82' and drain opening, here indicated by 83', extend only through the first insulating layer 66. In addition, gate opening, here indicated by 67', extends through both the first and the second insulating layers 66, 69.

Analogously, in this embodiment, spacer opening, here indicated by 71', and spacer regions, here indicated by 62', extend through the entire insulating structure 66, 69.

Shielding region 86 may be electrically coupled to other regions in the substrate 52 by forming one or more vias through first and second insulating layers 66, 69, in a position not shown in Figure 4.

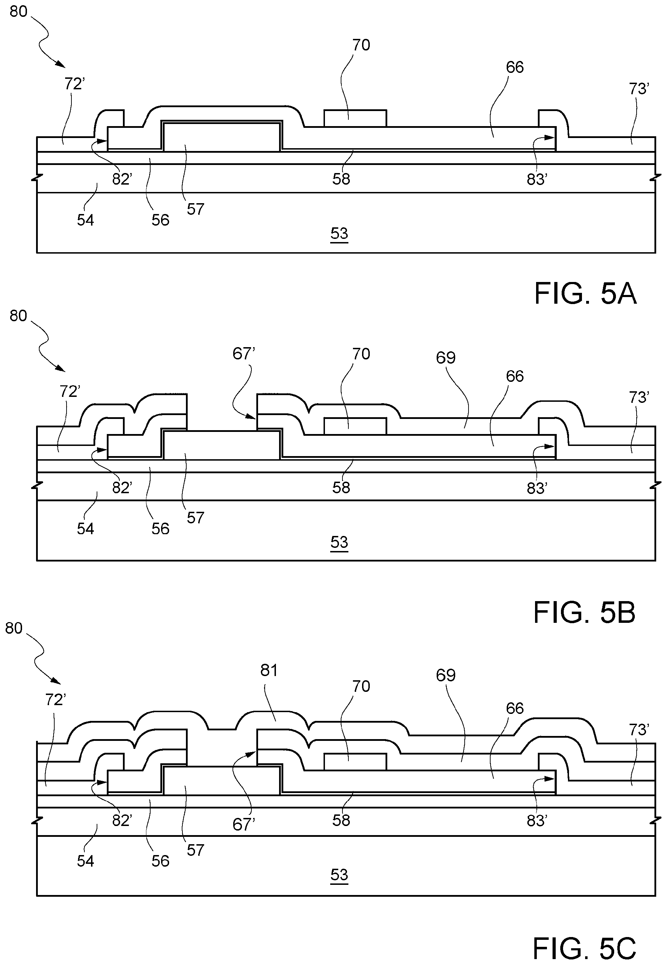

HEMT device 100 may be manufactured as shown in Figures 5A-5C.

In detail, in Figure 5A, after forming the first insulating layer 66 (Figure 3B), the latter is defined to form source opening 82' and drain opening 83'. Source metal region 72', drain metal region 73' and field plate 70 are then formed, by depositing and defining a same metal layer or stack, for example of Ti/AlCu/TiN.

In Figure 5B, second insulating layer 69 is deposited and etched (together with first insulating layer 66 and passivation layer 58) to form gate opening 67'.

Then, in Figure 5C, sacrificial layer 81 is deposited on the second insulating layer 69 and in gate opening 67', analogously to Figure 3D.

After blanket etching of sacrificial layer 81 and final manufacturing steps, as for the embodiment of Figure 2, the HEMT device 100 of Figure 4 is obtained.

In particular, as shown in Figure 4, while forming gate metal region, here indicated by 68' (e.g., by depositing and defining a metal layer or stack, for example Ti/AlCu/TiN) in spacer opening 71', a shielding region 86 may be formed from the same metal layer of gate metal 68'.

Figure 6 relates to a different embodiment, wherein regions common to HEMT device 50 of Figure 2 have been indicated using the same reference numbers. In Figure 6, an HEMT device 200 has a gate region 57' comprising a channel modulating region 90 (of pGaN material) and an interlayer region 59.

Channel modulating region 90 has the same structure and electrical features as gate region 57 of Figure 2.

Interlayer region 59, of conductive material, e.g., a metal such as TiN, extends on top of channel modulating region 90 and may be narrower than channel modulating region 90, along the second horizontal axis X of cartesian reference system XYZ.

Furthermore, interlayer region 59 is in direct electrical contact with gate metal region 68 at spacer opening 71 and extends under the spacer regions 62.

A passivation layer 58', analogous to passivation layer 58, covers the portions of the top surface of interlayer region 59 under the first insulating layer 66, the lateral surfaces of interlayer region 59, the edges of the top surface of channel modulating region 90, the sidewalls of channel modulating region 90 and the top surface of barrier layer 56.

Therefore, also in HEMT device 200 of Figure 6, passivation layer 58' extends at a distance from gate region 57' .

Interlayer region 59 operates to facilitate switchingon of channel modulating region 90 and to create a barrier to the diffusion of contaminants of upper layers.

Figure 7 relates to another embodiment, wherein an HEMT device 300 includes an interlayer region 59 (as described with reference to Figure 6) and wherein the source and the drain metal regions are formed before the gate metal region (as described with reference to Figure 4). In Figure 7, regions common to HEMT device 100 of Figure 4 and regions common to HEMT device 200 of Figure 6 have been indicated using the same reference numbers.

Interlayer region 59 has analogous position and features of the corresponding region shown in Figure 6.

Finally, it is clear that numerous variations and modifications may be made to the HEMT device and process described and illustrated herein, all falling within the scope of the invention, as defined in the attached claims.

Summarizing, example embodiments of the present disclosure are the following.

Example 1. An HEMT device (50; 100; 200; 300) comprising:
a semiconductor body (52) having a semiconductive heterostructure (54, 56);
a control region (57; 57'), comprising a semiconductor material, arranged on the semiconductor body (52), the control region (57; 57') having a top surface and lateral sides;
a control terminal (68; 68'), of conductive material, extending on and in contact with the top surface of the control region (57; 57'); and
a passivation layer (58; 58') of non-conductive material, extending on the semiconductor body (52), partially on the top surface of the control region (57; 57') and on the lateral sides of the control region (57; 57'),
the passivation layer (58; 58') arranged laterally and at a distance from the control terminal (68; 68').

Example 2. An HEMT device according to example 1, further comprising spacer regions (62; 62'), of non-conductive material, extending between the control terminal (68; 68') and the passivation layer (58; 58').

Example 3. An HEMT device according to the precedent example, wherein the control terminal (68; 68') comprises a narrow portion (68A), extending between the spacer regions (62; 62'), and an upper portion (68B), extending on the spacer regions.

Example 4. An HEMT device according to example 2 or 3, further comprising an insulating structure (66, 69) extending on the passivation layer (58; 58'), wherein a control opening (67; 67') extends in the insulating structure (66, 69) and through the passivation layer (58; 58') and accommodates, at least partially, the control terminal (68; 68') and the spacer regions (62; 62'), the control opening having lateral sides, the spacer regions (62; 62') extending on the lateral sides of the control opening (67; 67').

Example 4bis. An HEMT device according to any of the preceding examples, further comprising a first current conduction opening (82; 82') accommodating, at least partially, a first current conducting terminal (72; 72'), of conductive material; and
a second current conduction opening (83; 83') accommodating, at least partially, a second current conducting terminal (73; 73'), of conductive material.

Example 5. An HEMT device according to the preceding example, wherein the insulating structure (66, 69) comprises a first insulating layer (66) extending on passivation layer (58; 58'), and a second insulating layer (69) extending on the first insulating layer, and wherein the control opening (67) extends through the first insulating layer (66) and the passivation layer (58; 58') and accommodates the spacer regions (62) and, at least in part, the control terminal (68), the second insulating layer (69) extending on the control terminal (68).

Example 6. An HEMT device according to example 4, wherein the insulating structure (66, 69) comprises a first insulating layer (66) extending on passivation layer (58; 58'), and a second insulating layer (69) extending on the first insulating layer (66), and wherein the control opening (67') extends throughout the first and the second insulating layers (66, 69) and the passivation layer (58; 58') and accommodates the spacer regions (62') and the control terminal (68).

Example 7. An HEMT device according to any of examples 4-6, wherein the insulating structure (66, 69) and the spacer regions (62; 62') are of different, selectively etchable materials.

Example 8. An HEMT device according to the preceding example, wherein the insulating structure (66, 69) is of silicon oxide and the spacer regions (62; 62') are of silicon nitride.

Example 9. An HEMT device according to any of the preceding examples, wherein the control region (57') comprises a channel modulating region (90) and an interlayer region (59) overlying the channel modulating region.

Example 10. A process for manufacturing an HEMT device (50; 100; 200; 300), the process comprising:
on a semiconductor body (52) having a semiconductive heterostructure (54, 56), forming a control region (57; 57'), the control region (57; 57') including a semiconductor material and arranged on the semiconductor body (52), the control region (57; 57') having a top surface and lateral sides;
forming a passivation layer (58; 58') of non-conductive material, on the semiconductor body (52), partially on the top surface of the control region (57; 57') and on the lateral sides of the control region (57; 57'); and
forming a control terminal (68; 68'), of conductive material, on and in contact with the top surface of the control region (57; 57'), laterally and at a distance from the passivation layer (58; 58').

Example 11. A process according to the preceding example, further comprising, before forming a control terminal (68; 68'), forming spacer regions (62; 62'), of non-conductive material, extending between the control terminal (68; 68') and the passivation layer (58; 58').

Example 12. A process according to the preceding example, wherein:
forming a passivation layer (58; 58') and forming spacer regions (62) comprise:
   forming a portion of the passivation layer (58; 58') covering the top surface of the control region (57; 57');
   forming an insulating layer (66; 69) on the passivation layer (58; 58');
   forming a control opening (67; 67') in the insulating layer (66; 69), including selectively removing the portion of the passivation layer (58; 58'); and
   forming the spacer regions (62; 62') on lateral sides of the control opening (67; 67'); and
forming a control terminal (68; 68') comprises forming a portion of the control terminal in the control opening (67; 67'), between and on the spacer regions (62; 62').

Example 13. A process according to the preceding example,
wherein forming the spacer regions (62; 62') comprises:
forming a sacrificial layer (81) on the insulating layer (66; 69) and in the control opening (67; 67'); and
removing the sacrificial layer (81) from the insulating layer (66; 69) and in the control opening (67; 67'), except of at lateral sides of the control opening.

Example 14. A process according to the preceding example, wherein the insulating layer is a first insulating layer (66), the process further comprising:
after forming a control terminal (68), forming a second insulating layer (69);
forming a first and a second current conduction opening (82, 83) through the first and second insulating layers (66, 69) and the passivation layer (58; 58') on a first and, respectively, a second side of the control region (57; 57'); and
forming a first current conducting terminal (72) extending, at least partially, in the first current conduction opening (82) and a second current conducting terminal (73) extending, at least partially, in the second current conduction opening (83), the first and second current conducting terminals (72, 73) being in contact with the semiconductor body (52).

Example 15. A process according to example 13, further comprising a first insulating layer (66), wherein the insulating layer is a second insulating layer (69), the control opening (67') extending through both the first and the second insulating layers (66, 69), the process further comprising:
after forming the first insulating layer (66), forming a first and a second current conduction opening (82', 83') through the first insulating layer (66) and the passivation layer (58; 58'), on a first and, respectively, a second side of the control region (57; 57'); and
forming a first current conducting terminal (72') extending, at least partially, in the first current conduction opening (82') and a second current conducting terminal (73') extending, at least partially, in the second current conduction opening (83'), the first and second current conducting terminals being in contact with the semiconductor body (52).

## Claims

1. An HEMT device (50; 100; 200; 300) comprising:
a semiconductor body (52) having a semiconductive heterostructure (54, 56);
a control region (57; 57'), comprising a semiconductor material, arranged on the semiconductor body (52), the control region (57; 57') having a top surface and lateral sides;
a control terminal (68; 68'), of conductive material, extending on and in contact with the top surface of the control region (57; 57'); and
a passivation layer (58; 58') of non-conductive material, extending on the semiconductor body (52), partially on the top surface of the control region (57; 57') and on the lateral sides of the control region (57; 57'),
the passivation layer (58; 58') arranged laterally and at a distance from the control terminal (68; 68').

2. An HEMT device according to claim 1, further comprising spacer regions (62; 62'), of non-conductive material, extending between the control terminal (68; 68') and the passivation layer (58; 58').

3. An HEMT device according to the precedent claim, wherein the control terminal (68; 68') comprises a narrow portion (68A), extending between the spacer regions (62; 62'), and an upper portion (68B), extending on the spacer regions.

4. An HEMT device according to claim 2 or 3, further comprising an insulating structure (66, 69) extending on the passivation layer (58; 58'), wherein a control opening (67; 67') extends through the insulating structure (66, 69) and through the passivation layer (58; 58') and accommodates, at least partially, the control terminal (68; 68') and the spacer regions (62; 62'), the control opening having lateral sides, the spacer regions (62; 62') extending on the lateral sides of the control opening (67; 67').

5. An HEMT device according to the preceding claim, wherein the insulating structure (66, 69) comprises a first insulating layer (66) extending on passivation layer (58; 58'), and a second insulating layer (69) extending on the first insulating layer, and wherein the control opening (67) extends through the first insulating layer (66) and the passivation layer (58; 58') and accommodates the spacer regions (62) and, at least in part, the control terminal (68), the second insulating layer (69) extending on the control terminal (68).

6. An HEMT device according to claim 4, wherein the insulating structure (66, 69) comprises a first insulating layer (66) extending on passivation layer (58; 58'), and a second insulating layer (69) extending on the first insulating layer (66), and wherein the control opening (67') extends throughout the first and the second insulating layers (66, 69) and the passivation layer (58; 58') and accommodates the spacer regions (62') and the control terminal (68).

7. An HEMT device according to any of claims 4-6, wherein the insulating structure (66, 69) and the spacer regions (62; 62') are of different, selectively etchable materials.

8. An HEMT device according to the preceding claim, wherein the insulating structure (66, 69) is of silicon oxide and the spacer regions (62; 62') are of silicon nitride.

9. An HEMT device according to any of the preceding claims, wherein the control region (57') comprises a channel modulating region (90) and an interlayer region (59) overlying the channel modulating region.

10. A process for manufacturing an HEMT device (50; 100; 200; 300), the process comprising:
on a semiconductor body (52) having a semiconductive heterostructure (54, 56), forming a control region (57; 57'), the control region (57; 57') including a semiconductor material and arranged on the semiconductor body (52), the control region (57; 57') having a top surface and lateral sides;
forming a passivation layer (58; 58') of non-conductive material, on the semiconductor body (52), partially on the top surface of the control region (57; 57') and on the lateral sides of the control region (57; 57'); and
forming a control terminal (68; 68'), of conductive material, on and in contact with the top surface of the control region (57; 57'), laterally and at a distance from the passivation layer (58; 58').

11. A process according to the preceding claim, further comprising, before forming a control terminal (68; 68'), forming spacer regions (62; 62'), of non-conductive material, extending between the control terminal (68; 68') to be formed and the passivation layer (58; 58').

12. A process according to the preceding claim, wherein:
forming a passivation layer (58; 58') and forming spacer regions (62) comprise:
forming a portion of the passivation layer (58; 58') covering the top surface of the control region (57; 57');
forming an insulating layer (66; 69) on the passivation layer (58; 58');
forming a control opening (67; 67') through the insulating layer (66; 69) and the portion of the passivation layer (58; 58'); and
forming the spacer regions (62; 62') on lateral sides of the control opening (67; 67'); and
forming a control terminal (68; 68') comprises forming a portion of the control terminal in the control opening (67; 67'), between and on the spacer regions (62; 62').

13. A process according to the preceding claim,
wherein forming the spacer regions (62; 62') comprises:
forming a sacrificial layer (81) on the insulating layer (66; 69) and in the control opening (67; 67'); and
removing the sacrificial layer (81) from the insulating layer (66; 69) and in the control opening (67; 67'), except of at lateral sides of the control opening.

14. A process according to the preceding claim, wherein the insulating layer is a first insulating layer (66), the process further comprising:
after forming a control terminal (68), forming a second insulating layer (69);
forming a first and a second current conduction opening (82, 83) through the first and second insulating layers (66, 69) and the passivation layer (58; 58') on a first and, respectively, a second side of the control region (57; 57'); and
forming a first current conducting terminal (72) extending, at least partially, in the first current conduction opening (82) and a second current conducting terminal (73) extending, at least partially, in the second current conduction opening (83), the first and second current conducting terminals (72, 73) being in contact with the semiconductor body (52).

15. A process according to claim 13, wherein the insulating layer comprises a first insulating layer (66) and a second insulating layer (69) on the first insulating layer (66), the control opening (67') extending through both the first and the second insulating layers (66, 69), the process further comprising:
after forming the first insulating layer (66), forming a first and a second current conduction opening (82', 83') through the first insulating layer (66) and the passivation layer (58; 58'), on a first and, respectively, a second side of the control region (57; 57'); and
forming a first current conducting terminal (72') extending, at least partially, in the first current conduction opening (82') and a second current conducting terminal (73') extending, at least partially, in the second current conduction opening (83'), the first and second current conducting terminals being in contact with the semiconductor body (52).
